(19)

Europäisches
Patentamt
European
Patent Office
Office européen
des brevets

(11) **EP 4 387 029 A1**

(12) **EUROPEAN PATENT APPLICATION**

(43) Date of publication:
**19.06.2024 Bulletin 2024/25**

(21) Application number: **22214061.8**

(22) Date of filing: **16.12.2022**

(51) International Patent Classification (IPC):
*H02J 1/10* (2006.01)        *H02J 1/14* (2006.01)

(52) Cooperative Patent Classification (CPC):
**H02J 1/14; H02J 1/106**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ABB SCHWEIZ AG**
**5400 Baden (CH)**

(72) Inventors:
• **Danci, Alex**
  **65320 Vaasa (FI)**
• **Ikäheimo, Jouni**
  **65320 Vaasa (FI)**

(74) Representative: **Kolster Oy Ab**
**Salmisaarenaukio 1**
**P.O. Box 204**
**00181 Helsinki (FI)**

(54) **ELECTRIC APPARATUS OF AND ELECTRIC METHOD FOR ELECTRIC MACHINE**

(57)    An electric apparatus of an electric machine (2) comprises a transformer (100), a primary coil (100A) of the transformer (100) receiving electric energy from a harvesting electric circuit (102) located within an electric machine (104) and a secondary coil (100B) of the trans-
former (100) receiving electric energy of the harvested electric energy from the primary coil (100A) inductively. The secondary coil (100B) outputs the received electric energy for a battery charger (108) of a monitoring system (10) of the electric machine (2).

FIG. 1

EP 4 387 029 A1

## Description

### Field

The invention relates to an electric apparatus for an electric machine and an electric method of an electric machine.

### Background

Currently, wireless and IP66/67 sealed condition monitoring devices are manufactured with a non-replaceable battery that provides up to 15 years of low data-rate use. Although this kind solution has served well, it would be desirable to have more and/or more efficient measurement, increase data rates and wireless communication range, higher power and/or provide "edge device" data analysis.

### Brief description

The present invention seeks to provide an improvement in the measurements.
The invention is defined by the independent claims. Embodiments are defined in the dependent claims.
If one or more of the embodiments is considered not to fall under the scope of the independent claims, such an embodiment is or such embodiments are still useful for understanding features of the invention.

### List of drawings

Example embodiments of the present invention are described below, by way of example only, with reference to the accompanying drawings, in which

Figure 1 illustrates an example of an electric apparatus of an electric machine, which comprises an electric transformer for inductive electric energy transfer;
Figure 2 illustrates an example of detection of a load and/or electric current flow related to the stator of the electric machine;
Figure 3 illustrates an example of voltage U3 of a harvesting circuit 102 as a function of a motor load in percentages;
Figure 4 illustrates an example of an electric circuit for performing a temperature measurement;
Figure 5 illustrates a still another view of the alternating temperature measurement and charging;
Figure 6 illustrates an example of a controller; and
Figure 7 illustrates of an example of a flow chart of an electric method.

### Description of embodiments

The following embodiments are only examples. Although the specification may refer to "an" embodiment in several locations, this does not necessarily mean that each such reference is to the same embodiment(s), or that the feature only applies to a single embodiment.
The articles "a" and "an" give a general sense of entities, structures, components, compositions, operations, functions, connections or the like in this document. Note also that singular terms may include pluralities.
Single features of different embodiments may also be combined to provide other embodiments. Furthermore, words "comprising" and "including" should be understood as not limiting the described embodiments to consist of only those features that have been mentioned and such embodiments may also contain features/structures that have not been specifically mentioned. All combinations of the embodiments are considered possible if their combination does not lead to structural or logical contradiction.
The term "about" means that quantities or any numeric values are not exact and typically need not be exact. The reason may be tolerance, resolution, measurement error, rounding off or the like, or a fact that the feature of the solution in this document only requires that the quantity or numeric value is approximately that large. A certain tolerance is always included in real life quantities and numeric values.
The present solution is designed to overcome at least partly one or more of the prior art problems. The present solution enables a delivery of electric power harvested in a galvanically isolated way from the electric machine such as a motor through a sealed plastic housing to an electric circuitry. The electric machine may be monitored by a monitoring system which may have a sensor and information on the electric machine may be transmitted wirelessly by a transmitter fed by the harvested electric energy. In this manner, the sensor batteries have access to recharging energy in a galvanic or non-galvanic manner, enabling features requiring more electric power and/or more frequent monitoring events.

Automatic greasers, electric heaters, automation equipment, for example, as well as sensors and indicators related to state of the electric machine because with a possibility to increase digitalization, more diagnostic sensors may also be added into the electric machine to monitor the operational health.

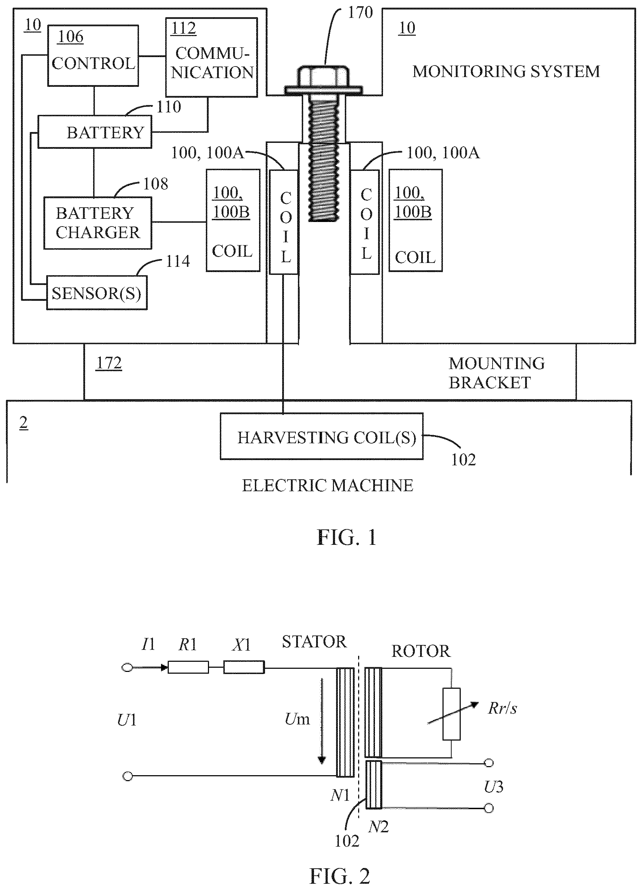

Fig. 1 illustrates an example of an electric apparatus of an electric machine 2, the electric apparatus comprising an electric transformer 100 for inductive electric energy transfer.

The electric apparatus comprises a transformer 100, a primary coil 100A of the transformer 100 receives electric energy from a harvesting electric circuit 102, the harvesting circuit 102 being located within an electric machine 2. A secondary coil 100B of the transformer 100 receives electric energy of the harvested electric energy from the primary coil 100A inductively. The secondary coil 100B outputs the received electric energy for a battery charger 108 of a monitoring system 10 of the electric machine 2.

The electric machine 2 may be an electric motor or an electric generator. The harvesting electric circuit 102 may comprise a plurality of harvesting circuits coupled to and/or associated physically with a stator of the electric machine. The one or more harvesting circuit 102 of the stator of the electric machine are known, *per se.*

The harvesting circuit 102 in conjunction with the stator may provide one to ten watts (W) of power without limiting to that power range. In some instances, for harvesting power, the harvesting electric circuit 102 may produce a sinusoidal alternating current (AC) voltage without limiting to that form of voltage variation. Additionally, or alternatively, the harvesting electric circuit 102 may produce a single phase, a three-phase, and/or any other number of phases of power. A secondary coil 100B of transformer 100 receives electric energy of the harvested electric energy from the primary coil 100A inductively, and the secondary coil 100B outputs the received electric energy for a battery charger 108. That the secondary coil 100B of transformer 100 receives electric energy from the primary coil 100A inductively refers to magnetic interaction between the primary coil 100A and the secondary coil 100B, the magnetic interaction being known from general operation of electric transformers, *per se.*

The harvesting electric circuit 102 may comprise a polyimide flexible PCB (printed circuit board) harvester winding, for example, that rests on a top of the stator windings in the stator slots of the electric machine, for example. During operation of the electric machine, the PCB winding and the stator winding interact inductively causing electric energy to the harvesting electric circuit 102. This voltage is robust. The harvesting electric circuit 102 need not be in stator winding slots but it may lay on an inner diameter of the stator, in an airgap between the rotor and stator of the electric machine 2.

This arrangement overcomes a technical challenge of how to provide electric power in a galvanically isolated way from the electric machine 2 the monitoring system 10 through a sealed housing. The housing may be plastic or made of other dielectric material, for example.

In an embodiment an example of which is illustrated in Fig. 1, the primary coil 100A and the secondary coil 100B of the transformer 100 are built round a mounting stud 170 of the monitoring system 10 of the electric machine 2. The stud 170 and mounting bracket 172 may act as a core of the transformer 100. The secondary coil 100B may be inside the monitoring system 10.

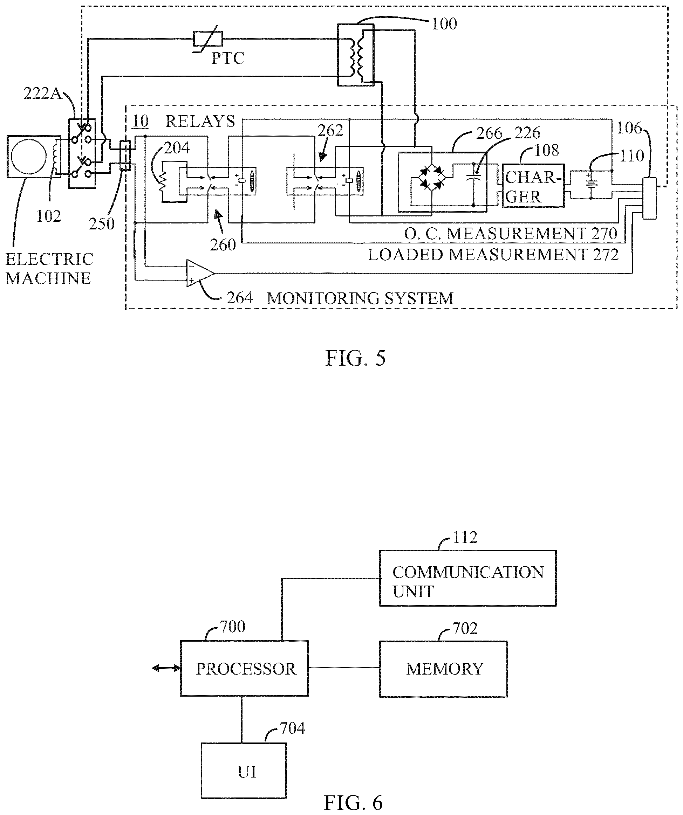

Inside the monitoring system 10, the harvested electric energy may be utilized one or more ways. In an embodiment, the electric apparatus comprises the battery charger 108 and the chargeable battery 110. The battery charger 108 can then charge the battery 110 with the harvested electric energy for the operation the monitoring system 10 at least partly. In an embodiment where energy is needed only when the electric machine is in operation, the battery charger and battery can be replaced with a rectifier, filter capacitor 226 (see Fig. 6) and voltage regulator (not shown). Alternatively, the battery charger and the battery may be passed by electric conductors 2.

The monitoring system 10 may comprise a controller 106, which may receive electric energy from the battery 110 for its operation to monitor the electric machine 102 based on signals from at least one sensor 114. Also, the at least one sensor 114 may receive electric energy from the battery 110 for its operation. In an embodiment, the monitoring system 10 may comprise a communication unit 112, which may communicate with a counterpart that may be in the same room, facility or further away, i.e. in environment of and separate from the electric machine 2 and the monitoring system 10. The counterpart may comprise a computer for data analysis, for example. The communication unit 112 may be wired or wireless. The communication may be performed through wired connection, wireless connection, or a combination of wired and wireless connection. Communication may also be by indicator lights or electromagnetic semaphore signals. The communication unit 112 may also receive energy from the battery 110 which is charged with the harvested energy, which means the communication may be based on and/or enabled by the harvested electric energy. The controller 106 of the monitoring unit 106 and/or the battery charger 108 may thus have access to recharging energy, which enables features requiring more power, more frequent monitoring events and/or higher data rates for communication. The harvested energy may be utilized by allowing the battery recharger 10 to recharge the battery 110 of the monitoring system 10.

In an embodiment, the monitoring unit 106 may comprise or is connected with at least one sensor 114 that may receive the harvested electric power for measuring the electric machine 2. The sensor 114 may measure an operational property of the electric machine 2. In an embodiment the sensor 114 may measure vibration of the electric machine 2. The vibration sensor may be a piezoelectric accelerometer or solid-state MEMS (Micro ElectroMechanical Systems), for example. A person skilled in the art is familiar with the vibration sensors, *per se.* In an embodiment the sensor 114 may measure magnetic flux of the electric machine 2. The controller 106 may process the signal and/or the data from the harvesting circuit 102, and also utilize the electric energy from the harvesting circuit 102 because the charging of the battery 110 and the signal/data processing may be performed at alternative periods i.e. in a time division multiplexed manner. The communication unit 112 then may transmit data on the measurements to data processing that is performed outside the monitoring system 10. The measurement of vibration of an electric machine may provide information on imbalances, bearing degradation, mounting problems and/or other undesired features that may be used in analysis to predict future breakdowns of the electric machine and time to breakdown, for example. It may be possible to avoid the breakdown by properly timed maintenance.

Additionally or alternatively, a quality or parameters of the harvested electric energy, such as frequency, magnitude or the like, may be utilized by the monitoring system 10 to derive useful information on the electric machine 2.

Fig. 2 illustrates an example of how to detect a load and/or electric current flow related to the stator of the electric machine 2. When it is a question of an electric motor, the electric current flow relates to electric current intake of the electric motor. A similar measurement principle applies to a measurement of a temperature of the stator.

A measurement of a motor load is used to determine an average load and efficiency of the motor in a particular application. Similar considerations apply also to the electric generator. Traditionally, the motor load has been measured from the motor input current using current sensors. These devices are expensive compared to motor cost, especially in mid-range and small motors.

In order to measure the motor input power in direct-on-line use, one must measure the motor current. The motor current has traditionally been measured with current transformers, which are expensive. Alternatively, the motor input power in a direct-on-line use can be measured based on a slip of the motor. The slip, which is required to produce torque to the electric motor, can be considered a difference between a rotation speed of the magnetic field and a rotation speed of the shaft of the motor. The motor slip can be measured from the rotation speed but the calibration requires an exactly known speed at 100 % load which is often not available with sufficient accuracy.

This document teaches how to turn the measurement of electric current into a simple voltage measurement of the harvested energy for determining the slip. A voltage U3 over the harvesting circuit 102 with its windings N2 may be expressed mathematically in the following manner:

$$U3 = a \cdot \frac{N2}{N1} \cdot \left( U1 - I1 \cdot (R1 + X1) \right) =>$$

$$I1 = \frac{a \cdot N2 \cdot U1 - N1 \cdot U3}{a \cdot N2 \cdot R1 + a \cdot N2 \cdot X1} \tag{1}$$

where $a$ is a coefficient depending on a ratio of coil and airgap areas in the stator, the term $\frac{N2}{N1}$ is a transformer ratio (in an conventional manner it can be considered as follows: N2 is a number of the winding of the stator, *N1* is a number of windings of the harvesting circuit 102), *U1* is a voltage fed to the stator winding, *R1* is a resistance of the stator winding and *X1* is a reactance of the stator winding. Increasing electric current *I1* causes a higher resistive voltage drop over the stator resistance which, in turn, causes a voltage U3, induced to the harvesting circuit 102 of the harvesting electric circuit 102.

The output voltage U3 of the harvesting circuit 102 is related to the motor design (flux density) and frequency (constant in direct-on-line use). By measuring the output voltage U3 of the harvesting circuit 102 with a proper precision, it is possible as explained above with the equation (1) to determine the input electric current *I1* and thus the loading state of the electric motor.

Namely, as the mechanical load of the rotor changes, the electric current *I1* flowing through the stator correspondingly changes. The electric current causes a voltage drop in the stator resistance, causing the voltage over an ideal transformer to drop. This drop reflects also to the induced voltage in the harvesting circuit 102 with winding *N2* through the transformer ratio between the stator coil and harvesting circuit 102. Thus, as the load decreases, the voltage induced in the harvesting circuit 102 rises as the resistive voltage drop in the stator decreases. The effect is up to several per cents, which can be detected by measuring an output voltage *U3* of the harvesting circuit 102. A variation of the main voltage is naturally also a source of error, if the variation is not known but the spectrum of induced voltage in the harvesting circuit 102 contains also sub-harmonics which are related to the motor load. One or more frequencies less than the fundamental frequency induced by the rotor to the harvesting circuit 102 can be called sub-harmonics. Any single sub-harmonic is the fundamental frequency divided by *k,* where *k* is a positive integer. Together with the RMS (root mean square) voltage, one can use this information to deduce the motor current even if the main voltage *U1* varies and the variation disturbs the direct measurement. In the case of an electric generator, the load may be determined in a corresponding manner.

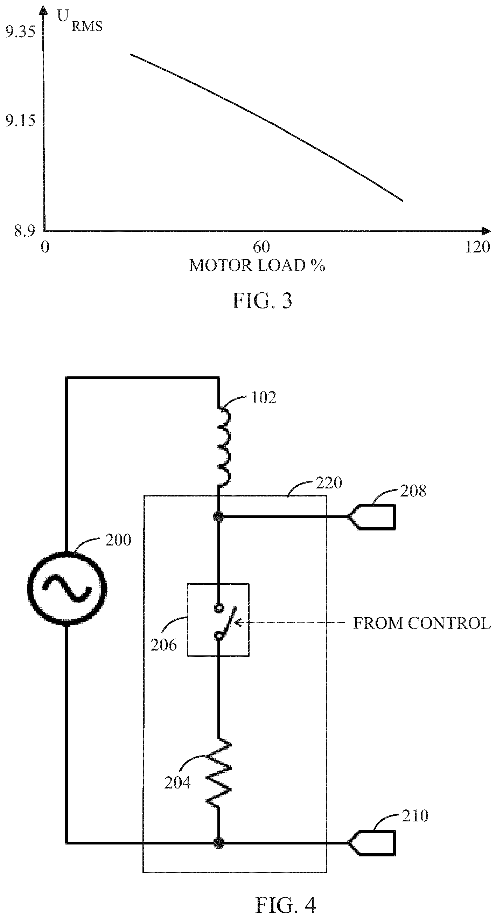

Fig. 3 illustrates an example of the voltage *U3* of the harvesting circuit 102 as a function of a motor load in percentages. The dependence between the voltage of harvesting circuit 102 and the motor load is almost linear.

In an embodiment, temperature related change of the stator coil resistance may be measured by measuring the temperature of the harvester coil *N2* of the harvesting circuit 102. In an embodiment, the effect of the temperature to the load and/or electric current measurement may be compensated.

In the prior art, temperature measurements in electric motors and generator's stators have been performed using thermocouples or temperature sensitive resistors, such as PT100, which measure the temperature outside the electric machine 2. These sensors may also be included in the winding during manufacture. However, these sensors may fail, and it is impossible to replace them, rendering the motor or generator without temperature measurement.

Resistance of the electrically conducting winding of the stator varies in a known way with temperature, so the winding can be used to determine the temperature of the stator. The winding is typically made of metal wire, the metal conventionally being copper and/or aluminum. Both of these metals, like metals in general, have well-known temperature dependent resistance. The stator temperature can be determined from the stator resistance. This information is useful for understanding the condition of the electric machine 2. One additional advantage of this concept is that temperature monitoring can be added after the stator has been manufactured. That is, the harvesting circuit 102 can be added to the stator as a retrofit in the field.

Fig. 4 illustrates a simplified circuit that may perform the temperature measurement. The coil of the harvesting circuit 102 that harvests energy from a flux of the electric machine 2 is in an intimate contact with the inner diameter of the stator of the electric machine 2. As a result, the harvesting circuit 102 is in the same condition as the stator and carries information on the temperature close to the stator core. During operation, a direct, 4-wire, resistance measurement of the harvesting circuit 102 is problematic due to the induced voltage over the harvesting circuit 102. The alternating magnetic flux in the harvesting circuit 102 generates an alternating emf (electromagnetic force). The harvesting circuit 102 can be idealized as an emf in series with a reactance. The DC (direct current) resistance of a 16 cm x 6 cm printed coil with 12 turns, for example, is about 1.26 ohms. As the impedance of the harvesting circuit 102 is low, less than about $50\mu H$, the equivalent reactance at 50Hz is less than about 0.01 ohm and can be ignored.

Referring to Fig. 4, the harvesting circuit 102 is in series with the flux generated emf 200 which appears as a voltage source. A point 210 may be 0 V as a reference. All voltages are RMS (root mean squares). A first switch 206, which may be controlled by the controller 106 of the monitoring system 10, and load resistor 204 may complete a temperature measurement circuit 220. When the first switch 206 is open, a voltage between points 208 and 210 represents an open circuit voltage ($V_{oc}$) that corresponds to the emf 200. When the first switch 206 is closed, the load resistor 204 is placed in the circuit completing a voltage divider with the resistance of coil 202. The voltage between 208 and 210 now represents a loaded voltage ($V_L$). The resistance of the coil ($R_c$) can be calculated knowing the value the load resistor 204 ($R_L$):

$$R_c = \left(\frac{V_{oc} \cdot R_L}{V_L}\right) - R_L \qquad (2)$$

Knowing $R_c$ and the resistance of the coil at 20°C ($R_{c20}$) it is then possible to calculate the temperature **T** of the coil in °C. (for Cu, a20 = 0.00392/°C):

$$T = \frac{\frac{R_c}{R_{c20}} - 1}{a20} + 20 \qquad (3)$$

Fig. 5 illustrates a still another view of the alternating current/load measurement, temperature measurement and charging. The harvesting circuit (coil) 102 may be fixed to the inner diameter of the of the stator of the electric machine 2. Leads of the harvesting circuit 102 are brought into the monitoring system 10 via hermetic feedthrough 250. The leads of the harvesting circuit 102 are connected to the movable contacts of double changeover relay 260, which is one switch of the switch arrangement, and the high impedance input of a true RMS-to-DC converter 264. Instead of the RMS-to-DC converter 264, component 264 may be comprise an instrumentation amplifier and the true RMS calculations may be carried out in the controller 106. The normally open contacts of the relay 260 are connected to load resistor 204. The normally closed contacts of relay 260 are connected to the movable contacts of double changeover relay 262, which is one switch of the switch arrangement. The switch 206 and the relays 260, 262 correspond to each other although the total arrangement in Fig. 5 is more versatile than that of Fig. 4. The normally closed contacts of the relay 262 are connected to the input of a rectifier 266, which may be connected to a charger 108. The normally open contacts of relay 262 may remain unconnected to anything. The output of the true RMS-to-DC converter 264 may be connected to the controller 106 where an analog-to-digital converter and microprocessor perform calculations to determine the temperature of the harvesting circuit 102 and communicate this information along with other sensor readings to further processing such as a condition monitoring system. During operation as a battery charger, signals named O.C. Measurement 270 and Loaded Measurement 272 are both in a high state so that the relay 260 and relay 262 are not energized. In this state, the emf from the harvesting circuit 102 is conducted through the transformer 100 to the rectifier 266. To measure temperature, the relay 260 and 262 are energized as follows and voltage readings (RMS) from the true RMS-to-DC converter 264 are stored as variables for the temperature calculation as described.

1 - O.C. Measurement 270 forced low, $V_{oc}$=[RMS]

2 - Loaded Measurement 272 forced low, $V_L$=[RMS]

3 - O.C. Measurement 270 and Loaded Measurement 272 forced high

4 - Resistance of the harvesting circuit 102 is calculated: $R_c = \left( \dfrac{V_{oc} R_L}{V_L} \right) - R_L$

5 - Temperature of the harvesting circuit 102 may be calculated based on the calculated resistance, the temperature estimating also the temperature of the stator: $T = \dfrac{\frac{R_c}{R_{c20}} - 1}{a20} + 20$ . Note also that the temperature of the stator may be calculated directly without separately calculating value for resistance of the harvesting circuit 102:

$$T = \dfrac{\frac{\frac{V_{oc} R_L}{V_L} - R_L}{R_{c20}} - 1}{a20} + 20$$ .

The temperature measurements may be carried out sequentially by disconnecting the power supply from the harvesting circuit 102 by energizing the relay 262 and measuring $V_{oc}$. The relay 260 is then energized, placing load resistor 204 across the harvesting circuit 102 to measure $V_L$. Several readings may be registered, and a value of the temperature T may be calculated as an average, for example. During the measurement, the monitoring system 10 receives electric power from the battery 108.

The switch arrangement 260, 262 may switch between three alternative states: a first state, a second state and a third state. The first state may enable a measurement of voltage over of the harvesting circuit 102 without load. A second state may connect a load known resistor 204 in series with the harvesting circuit 102 for enabling a measurement of voltage over the known load resistor 204. The switch arrangement 260, 262 may block electric energy feed from the harvesting circuit 102 to any other electric circuit the harvesting coil 102 in the first and second state except for the measurements.

The switch arrangement 260, 262 feeds electric energy from the harvesting circuit 102 to the charger 108 for charging the battery 110 in the third state. The controller 106 may control the switching arrangement 260, 262 as a function of charging level of the battery 110.

As to Fig. 5, the apparatus may work without the switch arrangement 222A, the PTC, the transformer 100 and the connection between the controller 106 and the switch arrangement 222A. Then the O.C. Measurement line connects the controller 106 and the relay 262. Correspondingly, the Loaded Measurement line 272 connects the controller 106 and the relay 260. The controller 106 may control the relay 262 via O.C. Measurement line 270 for the open circuit measurement and correspondingly the relay 260 via Loaded Measurement line 272 for loaded circuit measurement.

The transformer 100 galvanically separates the electric circuitry in the monitoring system 10 and electric circuitry in the stator side which includes the harvesting coil 102. But when the monitoring system 10 is electrically connected with the harvesting coil 102 using the relay 222A, the harvesting coil 102 and the monitoring system 10 are galvanically connected, and the relays 260, 262 are then in a rest state and the charger 108 receives electric energy from the harvesting coil 102 without the transformer 100.

Fig. 6 illustrates an example of the controller 106. The controller 106, which may be a computer, comprises one or more processors 700 and one or more memories 702 including computer program code. The one or more memories 702 and the computer program code are configured to, with the one or more processors 700, cause apparatus at least to determine an operational property of the electric machine 2. Additionally, the controller 106 may comprise or be connected with a communication unit 112 and/or user interface 704.

The term "computer" includes a computational device that performs logical and arithmetic operations. For example, a "computer" may comprise an electronic computational device, such as an integrated circuit, a microprocessor, a mobile computing device, a laptop computer, a tablet computer, a personal computer, or a mainframe computer. A "computer" may comprise a central processing unit, an ALU (arithmetic logic unit), a memory unit, and a control unit that controls actions of other components of the computer so that steps of a computer program are executed in a desired sequence. A "computer" may also include at least one peripheral unit that may include an auxiliary memory (such as flash memory), and/or may include data processing circuitry.

The user interface 704 means an input/output device and/or unit. Nonlimiting examples of a user interface include a touch screen, other electronic display screen, keyboard, mouse, microphone, handheld electronic controller, digital stylus, display screen, speaker, and/or projector for projecting a visual display.

The controller 106 may be at least partially implemented as a logic circuit solution or computer program. The computer program may be placed on a computer program distribution means for the distribution thereof. The computer program distribution means is readable by a data processing device, and it encodes the computer program commands, carries out the measurements and optionally controls the processes on the basis of the measurements.

The computer program may be distributed using a distribution medium which may be any medium readable by the controller. The medium may be a program storage medium, a memory, a software distribution package, or a compressed software package. In some cases, the distribution may be performed using at least one of the following: a near field communication signal, a short distance signal, and a telecommunications signal.

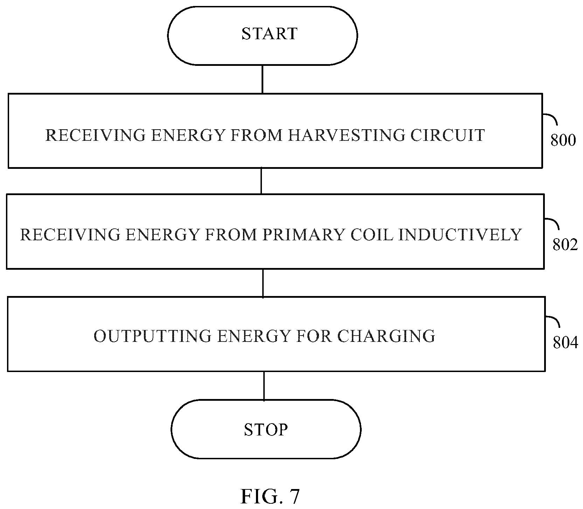

Fig. 7 is a flow chart of the electric method. In step 800, electric energy from a harvesting electric circuit 102 located within an electric machine 104 is received 800 by a primary coil 100A of a transformer 100. In step 802, electric energy of the harvested electric energy is received from the primary coil 100A inductively by a secondary coil 100B of the transformer 100. In step 804, the received electric energy is output for a battery charger 108 of a monitoring system 10 of the electric machine 2.

It will be obvious to a person skilled in the art that, as technology advances, the inventive concept can be implemented in various ways. The invention and its embodiments are not limited to the example embodiments described above but may vary within the scope of the claims.

**Claims**

1. A electric apparatus of an electric machine, **characterized in that** the electric apparatus comprises a transformer (100), a primary coil (100A) of the transformer (100) being configured to receive electric energy from a harvesting electric circuit (102) located within an electric machine (104) and a secondary coil (100B) of the transformer (100) being configured to receive electric energy of the harvested electric energy from the primary coil (100A) inductively and output the received electric energy for a battery charger (108) of a monitoring system (10) of the electric machine (2).

2. The apparatus of claim 1, **characterized in that** the apparatus comprises a chargeable battery (110), the battery charger (108) being configured to charge a battery (110) of the monitoring system (10) with the harvested electric energy for the operation of the monitoring system (10) at least partly.

3. The apparatus of claim 1, **characterized in that** the apparatus comprises at least one sensor (114) that is configured to receive the harvested electric power for measuring an operational property of the electric machine (2).

4. The apparatus of claim 3, **characterized in that** the at least one sensor (114) is configured to measure vibration of the electric machine (2).

5. The apparatus of any of the preceding claims, **characterized in that** the apparatus comprises a communication unit (112) that is configured to receive electric energy harvested by the harvesting circuit (102), and communicate outside the apparatus.

6. The apparatus of claim 1, **characterized in that** the apparatus comprises a switch arrangement (222A, 222B), which is configured to switch between two alternative states: a first state and a second state;

 the first state being configured to enable a measurement of voltage over of the harvesting circuit (102); and
 the second state being configured to feed electric energy from the harvesting circuit (102) to the charger (108).

7. The apparatus of claim 6, **characterized in that** the controller (106) is configured to determine a load, an electric input current or an electric output current of the electric machine (2) based on measurements of the first state.

8. The apparatus of claim 6, **characterized in that** the apparatus comprises a switch arrangement (260, 262), which is configured to switch between three alternative states: a first state, a second state and a third state;

the first state being configured to enable a measurement of voltage of the harvesting circuit (102) without load, a third state being configured to connect a known load known resistor (204) in series with the harvesting circuit (102) for enabling a measurement of voltage over the known load resistor (204); and

the switch arrangement being configured to block electric energy feed from the harvesting circuit (102) to any other electric circuit in the first and third state except for the measurements.

9. The apparatus of claim 6, **characterized in that** the controller (106) is configured to determine a temperature of the stator of the electric machine (2) based on measurements in the first state and the third state.

10. The apparatus of claim 6, **characterized in that** the controller (106) is configured to control the switching arrangement (260, 262).

11. The apparatus of claim 6 or 8, **characterized in that** the controller (106) is configured to control the switching arrangement (260, 262) as function of charging level of the battery (110).

12. The apparatus of claim 1, **characterized in that** the controller (106) comprises one or more processors (700); and

   one or more memories (702) including computer program code;
   the one or more memories (702) and the computer program code configured to, with the one or more processors (700), cause apparatus at least to:
   determine an operational property of the electric machine (2).

13. An electric method for an electric machine, **characterized by** receiving (800), by a primary coil (100A) of a transformer (100), electric energy from a harvesting electric circuit (102) located within an electric machine (104);

   receiving (802), by a secondary coil (100B) of the transformer (100), electric energy of the harvested electric energy from the primary coil (100A) inductively; and
   outputting (804) the received electric energy for a battery charger (108) of a monitoring system (10) of the electric machine (2).

14. The method of claim 13, **characterized by** charging, by the battery charger (108), a chargeable battery (110) of the monitoring system (10), with the harvested electric energy for the operation of the monitoring system (10) at least partly.

15. The method of claim 13, **characterized in that** switching, by a switch arrangement (260, 262), between three alternative states: a first state, a second state and a third state;

   the first state enables a measurement of voltage over of the harvesting circuit (102) without load, a third state connecting a known load resistor (204) in series with the harvesting circuit (102) and measuring voltage over the known load resistor (204); and
   blocking, by the switch arrangement, electric energy feed from the harvesting circuit (102) to any other electric circuit in the first and third state except for the measurements.

FIG. 1

FIG. 2

FIG. 3

FIG. 4

222A

10 RELAYS

PTC

100

204

262

266 226

106

108

110

CHAR-GER

250

260

O. C. MEASUREMENT 270

LOADED MEASUREMENT 272

264 MONITORING SYSTEM

102

ELECTRIC
MACHINE

FIG. 5

112

COMMUNICATION
UNIT

700

PROCESSOR

702

MEMORY

704

UI

FIG. 6

START

RECEIVING ENERGY FROM HARVESTING CIRCUIT — 800

RECEIVING ENERGY FROM PRIMARY COIL INDUCTIVELY — 802

OUTPUTTING ENERGY FOR CHARGING — 804

STOP

FIG. 7

Europäisches
Patentamt

European
Patent Office

Office européen
des brevets

## EUROPEAN SEARCH REPORT

Application Number

EP 22 21 4061

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GASNIER PIERRE ET AL: "An Autonomous Piezoelectric Energy Harvesting IC Based on a Synchronous Multi-Shot Technique", IEEE JOURNAL OF SOLID-STATE CIRCUITS, IEEE, USA, vol. 49, no. 7, 1 July 2014 (2014-07-01), pages 1561-1570, XP011552024, ISSN: 0018-9200, DOI: 10.1109/JSSC.2014.2325555 [retrieved on 2014-06-23] * the whole document * | 1-15 | INV. H02J1/10 H02J1/14 |
| X | CN 112 152 307 A (UNIV NINGBO) 29 December 2020 (2020-12-29) * abstract; claim 1; figure 1 * * paragraph [0002] - paragraph [0013] * | 1-15 | |
| A | US 2010/207399 A1 (GRANDICS PETER [US]) 19 August 2010 (2010-08-19) * abstract; claim 1; figure 2 * * paragraphs [0008] - [0014], [0031], [0044] - [0047], [0063] * | 1-15 | |
| A | JIANG JIN ET AL: "A Power Adaptive Energy Harvesting System Based on Magnetic Field Reverse Cancellation", 2021 IEEE 2ND CHINA INTERNATIONAL YOUTH CONFERENCE ON ELECTRICAL ENGINEERING (CIYCEE), IEEE, 15 December 2021 (2021-12-15), pages 1-6, XP034071358, DOI: 10.1109/CIYCEE53554.2021.9676789 [retrieved on 2022-01-10] * the whole document * | 1-15 | TECHNICAL FIELDS SEARCHED (IPC) H02J |

The present search report has been drawn up for all claims

| Place of search | Date of completion of the search | Examiner |
|---|---|---|
| Munich | 2 May 2023 | Rother, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 21 4061

This annex lists the patent family members relating to the patent documents cited in the above-mentioned European search report.
The members are as contained in the European Patent Office EDP file on
The European Patent Office is in no way liable for these particulars which are merely given for the purpose of information.

02-05-2023

| Patent document cited in search report | Publication date | Patent family member(s) | Publication date |
|---|---|---|---|
| CN 112152307 A | 29-12-2020 | NONE | |
| US 2010207399 A1 | 19-08-2010 | NONE | |

EPO FORM P0459